# FASCICULE DE BREVET EUROPEEN

(11) **EP 1 943 882 B1**
(45) Date de publication et mention de la délivrance du brevet: **11.03.2009**
(21) Numéro de dépôt: 06819202.0
(22) Date de dépôt: 31.10.2006
(51) Int. Cl.: H05B 33/22, G09F 13/22, H01L 51/52

(54) **DIODE ORGANIQUE ELECTROLUMINESCENTE A CAVITE OPTIQUE DE RESONNANCE ET A EXTRACTEUR SERVANT DE FILTRE SPATIAL DE LUMIERE**
ORGANISCHE LEUCHTDIODE MIT EINEM OPTISCHEN RESONATOR UND EINEM ALS RÄUMLICHES LICHTFILTER DIENENDEN EXTRAKTOR
ORGANIC LIGHT EMITTING DIODE HAVING A RESONANT OPTICAL CAVITY AND AN EXTRACTOR SERVING AS A SPATIAL LIGHT FILTER

(30) Priorité: 04.11.2005 FR 0553343
(43) Date de publication de la demande: 16.07.2008
(73) Titulaire: Thomson Licensing, 92100 Boulogne-Billancourt (FR)
(72) Inventeur: FERY, Christophe, 78078 Niedereschach (DE)
(74) Mandataire: Browaeys, Jean-Philippe
(86) Numéro de dépôt international: PCT/EP2006/067978
(87) Numéro de publication internationale: WO 2007/051799

(56) Documents cités:
- EP-A- 0 801 429
- WO-A-20/05098987
- US-A1- 2003 034 938
- US-A1- 2004 051 447
- US-A1- 2004 150 329

## Description

L'invention concerne une diode comprenant une couche organique électroluminescente intercalée entre une électrode inférieure et une électrode supérieure, et entre une couche réfléchissante inférieure et une couche réfléchissante supérieure, formant entre elles une cavité optique résonnante dans une direction normale auxdites couches pour un domaine de longueurs d'onde de la lumière apte à être émise par ladite couche électroluminescente, l'une au moins des électrodes ainsi que la couche réfléchissante située du même côté que cette électrode par rapport à ladite couche électroluminescente étant transparentes ou semi-transparentes à ladite lumière émise par la diode. L'invention concerne également un panneau d'affichage d'images comprenant une pluralité de telles diodes.

Le document US2004-051447 décrit des diodes de ce type, où l'une des couches réfléchissantes sert d'électrode, où l'autre électrode est transparente et positionnée du même côté, par rapport à la couche électroluminescente, que l'autre couche réfléchissante, qui est semi-transparente et formée d'un empilement réfléchissant de sous-couches diélectriques.

Lorsqu'on fait passer un courant électrique entre les électrodes d'une telle diode, une partie de la lumière qui est émise par la couche électroluminescente résonne dans la cavité optique et sort de la diode au travers de l'électrode transparente et de la couche diélectrique réfléchissante, avec une intensité d'émission maximum dans une direction normale par rapport au plan de cette couche.

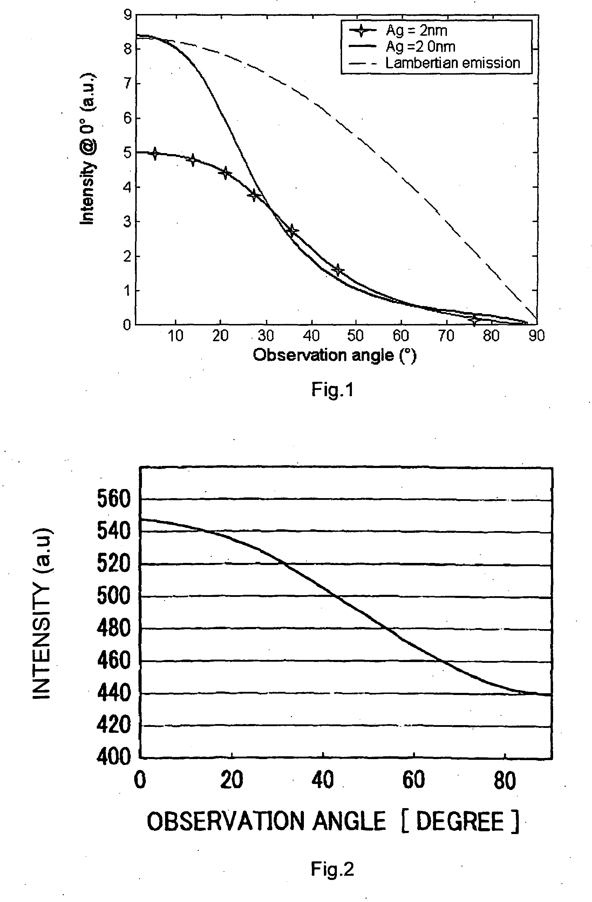

La figure 1 illustre la répartition de l'intensité d'émission d'une diode de ce type par rapport à l'angle d'observation (ou d'émission), évalué par rapport à la direction normale à cette diode ; la diode considérée ici présente la structure suivante : substrat/Ag (électrode inférieure opaque métallique et réfléchissante)/ couches organiques (y compris couche électroluminescente) / Ag (épaisseur 2 nm ou 20 nm) /ZnSe, où la couche diélectrique ZnSe est adaptée pour obtenir le minimum d'absorption de l'empilement Ag /ZnSe ; la couche diélectrique ZnSe peut être également adaptée pour optimiser les propriétés optiques de l'empilement Ag /ZnSe, comme décrit dans les documents EP1076368, EP1439589 et EP1443572. Cette figure 1 montre donc que, quelle que soit l'épaisseur de l'électrode supérieure en Ag (2 nm ou 20 nm), la répartition spatiale de l'émission d'une diode électroluminescente est beaucoup plus resserrée et directionnelle que celle d'une source de Lambert (courbe en traits tiretés).

Le document US6326224 enseigne la purification des couleurs que permet d'obtenir une cavité optique résonnante incorporée dans une diode ; on peut même avoir plusieurs cavités (ou micro-cavités) comme illustré dans le document US5949187.

Par ailleurs, la cavité optique entraîne une variation, avec la longueur d'onde de la répartition angulaire de l'émission, comme l'illustre la figure 7 du document US2004-051447 déjà cité, reprise ici en figure 2 : cette figure montre la position angulaire (en abscisse) du maximum d'émission en fonction de la longueur d'onde émise ; la longueur d'onde dont le maximum d'émission est orienté perpendiculairement à la diode (angle d'observation = 0) correspond à la longueur d'onde de résonance de la cavité dans une direction normale. Les . documents EP0801429, US2003/034938 et WO2005/098987 décrivent également ces variations de la répartition angulaire de l'émission en fonction des caractéristiques de la cavité optique de résonnance.

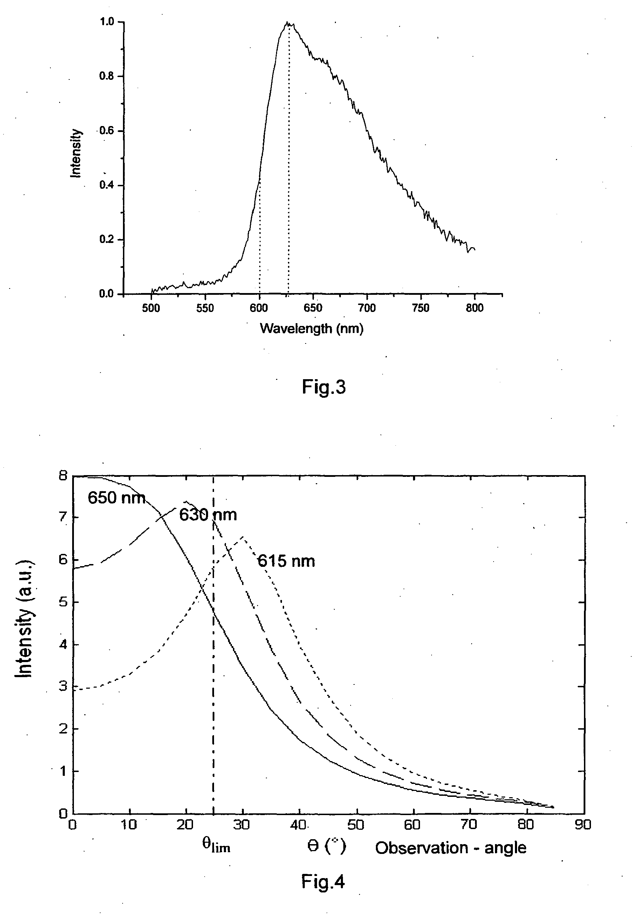

La figure 4 donne la répartition angulaire de l'émission d'une diode organique émettant dans le rouge et ayant la structure suivante : substrat / AI (électrode inférieure opaque réfléchissante)/ couches organiques (y compris couche électroluminescente) / Ag (20nm) / ZnSe (85nm) ; cette répartition est donnée pour trois différentes longueurs d'onde du spectre de fluorescence de la même couche électroluminescente : 650 nm pour la courbe en trait plein, 630 nm pour la courbe en traits tiretés, et 615 nm pour la courbe en traits pointillés. De cette figure 4, on peut déduire, comme déjà illustré par la figure 2, la variation de la position angulaire du maximum d'émission en fonction de la longueur d'onde émise (ici, seulement trois longueurs d'onde sont représentées). La figure 3 donne la répartition spectrale d'émission intrinsèque du matériau de la couche électroluminescente.

A cause de cette variation de la position angulaire du maximum d'émission en fonction de la longueur d'onde émise, un observateur placé devant la diode va donc percevoir des teintes de couleurs d'émission différentes selon l'angle d'observation de cette diode qu'il va choisir.

Pour résoudre ce problème de pureté de couleur, le document US2004-051447 propose d'adjoindre à la diode un dispositif d'extraction de lumière comprenant une lentille convergente et un masque doté d'une ouverture formant un diaphragme (« stop » en langue anglaise) pour cette lentille ; le diaphragme doit être positionné dans l'axe optique de la lentille, de manière à ne laisser passer que les rayons émis par la diode dans une direction proche de la normale à cette diode (angle d'observation nul) et à stopper les rayons émis selon un angle d'observation supérieur à un « angle de coupure », ce diaphragme étant positionné approximativement dans le plan focal de la lentille. L'angle de coupure est proportionnel à l'ouverture du diaphragme et inversement proportionnel à la distance entre la lentille et le diaphragme, qui correspond en général à la distance focale de la lentille. En supprimant une forte proportion de rayons dont l'intensité d'émission est maximum pour un angle d'émission supérieur à l'angle de coupure, le dispositif d'extraction proposé dans ce document permet d'améliorer sensiblement la pureté de couleur d'émission de la diode.

Un inconvénient des diodes décrites dans le document US2004-051447 réside dans les contraintes de positionnement des éléments du dispositif d'extraction. Un autre inconvénient est que l'émission de ces diodes conserve un caractère directionnel très marqué, la répartition spatiale de l'émission restant beaucoup plus resserrée que celle d'une source de Lambert.

Un autre inconvénient du dispositif d'extraction décrit dans le document

US2004-051447, du moins lorsque les diodes sont en réseau pour former un panneau d'affichage d'images, est qu'il nécessite de positionner une lentille sur chaque diode, ce qui engendre des contraintes d'alignement très pénalisantes pour la fabrication du panneau.

Un but de l'invention est de résoudre un ou plusieurs des inconvénients précités.

A cet effet, l'invention a pour objet une diode comprenant une couche organique électroluminescente intercalée entre une électrode inférieure et une électrode supérieure, et entre une couche réfléchissante inférieure et une couche réfléchissante supérieure, formant entre elles une cavité optique résonnante pour un domaine de longueurs d'onde de la lumière apte à être émise par ladite couche électroluminescente, l'une au moins des électrodes ainsi que la couche réfléchissante située du même côté que cette électrode par rapport à ladite couche électroluminescente étant transparentes ou semi-transparentes à ladite lumière émise, cette diode comprenant au moins un extracteur de lumière comprenant une section d'entrée de lumière optiquement couplée à la dite couche électroluminescente via ladite électrode et ladite couche réfléchissante qui sont transparentes ou semi-transparentes, une section de sortie de lumière qui est orientée vers l'extérieur de la diode et qui présente une surface inférieure à celle de la section d'entrée, et des parois latérales réfléchissantes qui sont délimitées par ladite section d'entrée et par ladite section de sortie.

La couche réfléchissante inférieure et la couche réfléchissante supérieure sont généralement parallèles ; la couche réfléchissante qui est semi-transparente est donc ici semi-réfléchissante.

De préférence, les électrodes servent également de couches réfléchissantes pour délimiter la cavité optique ; l'une des électrodes est par exemple formée d'une couche métallique épaisse, opaque, et réfléchissante, par exemple en aluminium ou en argent ; l'autre électrode peut être formée d'une sous-couche métallique suffisamment fine pour être à la fois réfléchissante et semi-transparente, par exemple une couche de 20 nm d'argent, et d'une sous-couche diélectrique transparente, par exemple en ZnSe, adaptée en nature et en épaisseur pour optimiser les propriétés optiques de cette électrode.

La distance D_{C} entre les électrodes correspond alors à la hauteur de la cavité résonnante ; comme l'enseigne le document US2003-034938, la condition de résonance dans cette cavité s'exprime par l'équation : 2π. 2 D_{C} / λ_{CN} + Φ = 2 π.m, où m est un nombre entier, en général égal à 1, et où φ désigne le déphasage global lors de la réflexion d'un rayon de longueur d'onde λ_{CN} sur chacune des couches réfléchissantes qui délimitent la cavité résonnante.

L'équation ci-dessus donne la longueur d'onde de résonance λ_{CN} pour une direction de propagation des rayons qui est normale aux couches réfléchissantes qui délimitent la cavité résonnante ; pour des directions de propagation qui s'éloignent de Ja normale, la longueur d'onde de résonance diminue, comme l'illustrent les figures 2 et 4.

Sur la figure 4, la longueur d'onde de résonance dans une direction normale est λ_{CN} = 650 nm (courbe en traits plein) ; les courbes en traits tiretés (630 nm) et pointillés (615 nm) montrent que l'intensité de la lumière sortant de la diode dans une direction normale reste significative même quand on s'éloigne de la longueur d'onde normale de résonance λ_{CN} : il existe donc un domaine de longueurs d'onde de, la lumière émise par la diode qui correspond donc à la direction normale d'émission.

Les sections d'entrée et de sortie de l'extracteur sont généralement planes et parallèles aux couches réfléchissantes de la diode, donc perpendiculaires à la direction normale d'émission.

Comme l'extracteur présente une section de sortie dont la surface est inférieure à celle de la section d'entrée, cet extracteur fonctionne en concentrateur ; comme il présente des parois latérales réfléchissantes, cet extracteur fonctionne en concentrateur par réflexion ; les rayons qui sortent de l'extracteur l'ont traversé soit directement sans réflexion, soit, au contraire, après une ou plusieurs réflexions sur les parois latérales.

Cet extracteur fonctionne donc par réflexion et non pas par réfraction comme dans le document US2004-150329, où les parois latérales sont réfractantes (et non pas réfléchissantes comme dans l'invention), cette réfraction étant destinée à re-diriger la lumière émise dans une direction se rapprochant de la direction non-hale.

Toutes les parois latérales de l'extracteur ne sont pas forcément réfléchissantes ; dans le cas d'un panneau comportant des diodes réparties en lignes et/ou en colonnes, chaque extracteur peut être commun à toutes les diodes d'une même ligne ou d'une même colonne ; cet extracteur comprend alors deux parois latérales réfléchissantes opposées, les deux autres parois latérales de cet extracteur étant déportées aux extrémités de la ligne ou de la colonne, et n'étant pas forcément réfléchissantes ; la section d'entrée de l'extracteur est alors optiquement couplée à un pluralité de diodes ; dans cette configuration, chaque diode de la ligne ne « voit » donc que deux portions de parois réfléchissantes opposées de l'extracteur.

La diode peut également comporter plusieurs extracteurs accolés de manière à ce que les sections d'entrée de ces extracteurs couvrent l'ensemble de la surface émissive de la diode ; la surface émissive est alors couplée à plusieurs sections d'entrée d'extracteur. Même dans ce cas, ces extracteurs peuvent également être communs à plusieurs diodes.

De préférence, pour obtenir l'effet de concentration, les parois latérales réfléchissantes de l'au moins un extracteur de la diode sont tournées vers sa section d'entrée : ceci signifie que la normale en tout point desdites parois réfléchissantes coupe cette section d'entrée en passant par l'intérieur de l'extracteur, ou, à défaut, est parallèle à cette section d'entrée.

De préférence, les parois latérales réfléchissantes de l'au moins un extracteur ont une forme adaptée pour que tout rayon de lumière émise qui pénètre par sa section d'entrée, qui est réfléchi au moins une fois par lesdites parois latérales, et qui ressort de l'extracteur par sa section de sortie en ressort sous un angle d'émission supérieur à l'angle d'émission de ce rayon à l'entrée de l'extracteur. On élargit ainsi la distribution angulaire de l'intensité d'émission, et on se rapproche avantageusement d'une distribution Lambertienne ; à noter que cet effet est exactement opposé, en utilisant des réflecteurs analogues, à celui apporté par les systèmes optiques décrits dans le document US6603243 (voir colonne 11, paragraphe 1 et figure 17) ; en effet, dans ce document, on cherche à limiter le champ (vertical) d'observation, contrairement à l'invention où on cherche à élargir le champ d'observation (horizontal, notamment).

La définition de la forme des parois latérales réfléchissantes inclut celle de la profondeur des extracteurs, c'est-à-dire de la distance entre la section d'entrée et la section de sortie ; elle inclut également la forme et la surface de ces sections dont les bords délimitent ces parois.

De préférence, les parois latérales réfléchissantes de l'au moins un extracteur ont une forme adaptée pour qu'il existe un angle dit de coupure θₗᵢₘ tel que :
- les rayons de lumière émise, qui pénètrent par sa section d'entrée sous un angle d'émission inférieur ou égal audit angle de coupure θ_{lim,} ressortent de cet extracteur par sa section de sortie, ledit angle d'émission étant évalué par rapport à une direction normale à ladite couche réfléchissante inférieure et à ladite couche réfléchissante supérieure ;
- les rayons de lumière émise, qui pénètrent par sa section d'entrée sous un angle d'émission supérieur à cet angle de coupure θₗᵢₘ, ne ressortent pas de l'extracteur par sa section de sortie.

En pratique, l'angle de coupure n'est pas absolu, au sens qu'il peut exister quelques rayons qui, bien qu'ayant un angle d'émission légèrement supérieur à l'angle de coupure, ressortent quand même de l'extracteur par sa section de sortie, et qu'il existe quelques rayons qui, bien qu'ayant un angle d'émission légèrement inférieur à l'angle de coupure, ne ressortent cependant pas de l'extracteur par sa section de sortie.

En référence à la figure 4, l'extracteur de la diode selon l'invention supprime donc une forte proportion de rayons de lumière émise ayant une longueur d'onde dont l'intensité d'émission est maximum pour un angle d'émission supérieur à l'angle de coupure θₗᵢₘ ; par un choix adapté de la valeur de cet angle, et donc de la forme des parois latérales réfléchissantes, le dispositif d'extraction proposé permet une sélection spatiale des longueurs d'onde de la lumière émise par la diode et une amélioration ou une adaptation de la pureté de couleur d'émission de cette diode, comme le dispositif à lentilles et diaphragmes décrit dans le document US2004-051447 précité, en évitant avantageusement les contraintes de positionnement des éléments de ce dispositif à lentilles.

La définition de la forme des parois latérales réfléchissantes inclut celle de la profondeur des extracteurs, c'est-à-dire de la distance entre la section d'entrée et la section de sortie ; elle inclut également la forme et la surface de ces sections dont les bords délimitent ces parois. Ainsi, si l'on souhaite exclure une forte proportion des rayons émis par la couche électroluminescente dès lors que ces rayons ont une longueur d'onde exclue d'un intervalle [λ_{CN}, λ_{C-lim}], où λ_{C-lim} est une longeur d'onde de coupure choisie inférieure à λ_{CN}, on détermine la géométrie des extracteurs de manière à ce que ledit angle de coupure θₗᵢₘ corresponde à cette longeur d'onde de coupure λ_{C-lim}.

Selon une première variante, de préférence, lesdites parois latérales réfléchissantes de l'au moins un extracteur sont formées par l'interface entre deux matériaux transparents d'indices optiques différents, et la forme de ces parois et la différence entre ces indices optiques sont adaptées pour que les rayons de lumière émise qui frappent les dites parois en provenance de l'intérieur dudit extracteur et de sa section d'entrée soient réfléchis par réflexion totale interne sur lesdites parois. Ces conditions sont à l'opposé de celles décrites dans le document US2004-150329 où ces rayons sont au contraire réfractés et transmis par cette interface.

Selon une deuxième variante, de préférence, lesdites parois latérales réfléchissantes sont métallisées. Tout rayon de lumière émise qui frappe les dites parois en provenance de l'intérieur dudit extracteur est alors réfléchi sur lesdites parois.

De préférence, lesdites parois latérales réfléchissantes de l'extracteur sont deux à deux symétriques par rapport à un plan orienté dans une direction normale à ladite couche réfléchissante inférieure et à ladite couche réfléchissante supérieure. Dans le cas de l'extracteur précédemment cité qui est commun à toutes les diodes d'une même ligne ou d'une même colonne d'un panneau de diodes, cet extracteur comprend alors deux parois latérales réfléchissantes opposées et symétriques par rapport à un plan parallèle à ladite ligne ou à ladite colonne. Dans le cas de sections d'entrée et de sortie rectangulaires ou carrées, on trouve généralement une première paire de parois latérales opposées qui sont symétriques par rapport à un premier plan, et une deuxième paire de parois latérales opposées qui sont symétriques par rapport à un deuxième plan, perpendiculaire au premier.

De préférence, lesdites parois latérales réfléchissantes présentent un axe de symétrie orienté dans une direction normale à ladite couche réfléchissante inférieure et à ladite couche réfléchissante supérieure.

De préférence, chacune des deux lignes d'intersection desdites parois latérales avec un plan de coupe quelconque de cette paroi qui est orienté dans une direction qui est normale à ladite couche réfléchissante inférieure et à ladite couche réfléchissante supérieure et qui est perpendiculaire audit plan de symétrie ou avec un plan de coupe quelconque passant par ledit axe de symétrie, forme une droite ou une parabole dont l'axe est dans ladite direction normale. De telles formes permettent d'obtenir avantageusement à la fois l'effet de concentration, puisque la section de sortie présente une surface plus petite que la section d'entrée, et la sélection spatiale des longueurs d'onde de la lumière émise par la diode, puisque de tels extracteurs présentent un angle de coupure tel que précédemment défini. Dans le cas de parois ayant un axe de symétrie, ces parois latérales réfléchissantes forment alors un cône ou un paraboloïde.

De préférence, chacune des deux lignes d'intersection desdites parois latérales avec un plan de coupe quelconque de cette paroi qui est orienté dans une direction qui est normale à ladite couche réfléchissante inférieure et à ladite couche réfléchissante supérieure et qui est perpendiculaire audit plan de symétrie ou avec un plan de coupe quelconque passant par ledit axe de symétrie, est inscrite dans la surface limitée par :
- d'une part, une droite joignant le point commun à ladite ligne d'intersection et à ladite section d'entrée et le point commun à ladite ligne d'intersection et à ladite section de sortie ;
- d'autre part, une parabole dont l'axe est approximativement parallèle à la droite joignant ce dernier point commun et le point commun à l'autre ligne d'intersection, symétrique de la précédente, et à ladite section d'entrée, et dont le foyer coïncide approximativement avec le point commun à cette autre ligne d'intersection et au bord de ladite section de sortie.

Les paraboles ainsi définies sont qualifiées de « paraboles CPC». L'inscription dans cette surface inclut ici les contours de cette surface.

De préférence, chacune des deux lignes d'intersection desdites parois latérales avec le plan de coupe coïncide approximativement avec cette parabole « CPC ». On remarque que la normale à chaque parabole de type « CPC » dans ledit plan de coupe, à l'endroit du point commun E, E' de cette parabole et du bord de la section d'entrée dudit extracteur, est perpendiculaire audit plan de symétrie ou audit axe de symétrie,

Les parois latérales forment alors un « CPC » (« compound parabolic concentrator » en langue anglaise), ce qui permet d'optimiser le rendement de concentration tout en élargissant la distribution angulaire de l'émission de la diode, contrairement au dispositif à lentilles et diaphragmes décrit dans la document US2004-051447. Par ailleurs, l'angle de coupure correspond alors à l'angle entre ce qu'on appelle le « rayon extrême » de cet extracteur et la direction normale ; ce rayon extrême appartient audit plan de coupe ; il se définit comme le rayon qui passe d'une part par le point commun au bord de la section d'entrée de l'extracteur et d'une première ligne d'intersection des parois latérales réfléchissantes de cet extracteur avec ce plan de coupe, et, d'autre part, par le point commun au bord de la section de sortie et d'une deuxième ligne d'intersection des parois avec ce plan de coupe, qui est symétrique de la première par rapport audit plan de symétrie ou audit axe de symétrie.

L'ouvrage intitulé « High Collection Nonimaging Optics », W.T. Welford & R.Winston, Academic Press, Inc 1989, définit précisément la forme des parois latérales d'un extracteur de type CPC, ainsi que sa profondeur et le rapport des surfaces des sections d'entrée et de sortie ; voir notamment le paragraphe 3 du chapitre 4 de cet ouvrage. Le document US6603243 illustre une application pour limiter l'angle de vue de panneaux de diodes électroluminescentes sans cavités résonnantes. Si 2a' est la distance entre deux bords opposés de la section de sortie d'un extracteur de ce type CPC dans le plan de coupe précédemment défini, si 2a est la distance entre deux bords opposés de la section d'entrée toujours dans ce plan de coupe, si θ_{C} est l'angle de coupure, ces trois paramètres sont liés par la relation : a = a' / sin θ_{C}. La profondeur L de l'extracteur, c'est-à-dire la distance entre la section d'entrée et la section de sortie, s'exprime par l'équation : L = (a + a') cos θ_{C}.

Ainsi, si par exemple θₗᵢₘ = 25°- voir figure 4, alors a' = 0,42 a , L = 1,42 a et on obtient un effet significatif de purification des couleurs (voir figure 3 - coupure figurant à environ 600 nm). Ainsi, si la largeur de la surface d'émission d'une diode est de 200 µm, et qu'elle correspond, par couplage optique, avec la largeur de la section d'entrée d'un extracteur CPC (a = 100 µm, donc a' = 42 µ m), on a alors L = 129 µm.

De préférence, la diode comprend une pluralité d'extracteurs. Ces extracteurs sont alors de préférence accolés de manière à ce que leurs sections d'entrée couvrent l'ensemble de la surface émissive de la diode.

L'espace compris entre les sections de sortie des extracteurs de la diode est avantageusement rendu opaque et non réflectif, formant ainsi un « réseau noir », ce qui améliore le contraste d'émission de la diode en lumière ambiante. Plus le rapport de concentration de l'extracteur est élevé, plus la surface disponible pour ce « réseau noir » est importante, meilleur est le contraste d'émission en lumière ambiante.

L'invention a également pour objet un panneau d'affichage d'images comprenant une pluralité de diodes selon l'invention, qui sont réparties sur un même substrat.

De préférence, chaque diode comprend une pluralité d'extracteurs, ce qui permet de s'affranchir des contraintes d'alignement entre chacun des extracteurs et chacune des diodes, et ce qui permet de diminuer la profondeur de ces extracteurs.

De préférence, ces extracteurs sont formés dans une même couche de matériau transparent qui recouvre l'ensemble du panneau ; cette couche est appelée « couche d'extraction ».

Selon une première variante, cette couche d'extraction est disposée à l'opposé du substrat par rapport à la couche électroluminescente et sert également de couche d'encapsulation pour protéger la couche électroluminescente contre les risques de dégradation.

Selon une deuxième variante, cette couche d'extraction sert de substrat.

De préférence, les diodes du panneau sont réparties en lignes et en colonne, et chaque extracteur est commun à plusieurs diodes d'une même colonne.

De préférence, chaque extracteur est commun à toutes les diodes d'une même colonne.

De préférence, les dites colonnes étant disposées verticalement pour être adaptées à l'affichage des images, lesdites parois latérales réfléchissantes de chaque extracteur commun à plusieurs diodes d'une même colonne sont deux à deux symétriques par rapport à un plan qui est orienté dans ladite direction normale et qui est parallèle à ladite colonne.

Ainsi, lorsque ces parois latérales réfléchissantes ont une forme adaptée pour que les rayons de lumière émise qui pénètrent par la section d'entrée de cet extracteur et qui sont réfléchis au moins une fois par lesdites parois latérales, ressortent de cet extracteur par sa section de sortie sous un angle d'émission supérieur à l'angle d'émission de ces rayon à l'entrée de l'extracteur, on obtient avantageusement un élargissement de la distribution horizontale de l'émission du panneau, c'est-à-dire une augmentation avantageuse de l'angle de vue horizontal du panneau.

L'invention sera mieux comprise à la lecture de la description qui va suivre, donnée à titre d'exemple non limitatif, et en référence aux figures annexées sur lesquelles :
- la figure 1, déjà décrite, donne la répartition de l'intensité d'émission de deux diodes de l'art antérieur en fonction de l'angle d'observation ;
- la figure 2, déjà décrite, correspond à la figure 7 du document US2004-051447 et donne, en fonction de l'angle d'observation, la longueur d'onde du maximum d'émission d'une diode de l'art antérieur, qui est dotée d'une cavité optique résonnante à 550 nm environ dans une direction normale ;
- la figure 3, déjà décrite, donne le spectre intrinsèque d'électroluminescence d'un matériau organique de l'art antérieur, émettant dans le rouge ;
- la figure 4, déjà décrite, donne, pour trois longueurs d'onde différentes, la répartition, en fonction de l'angle d'observation, de l'intensité d'émission d'une diode de l'art antérieur qui comprend une couche électroluminescente en matériau de la figure 3 et une cavité optique qui résonne dans la direction normale pour une longueur d'onde de 650 nm ;
- la figure 5 est une vue en coupe d'un panneau de diodes selon un premier mode de réalisation de l'invention ;
- la figure 6 est une vue détaillée en coupe d'une diode du panneau de la figure 5;
- la figure 7 est une vue détaillée en coupe des extracteurs du panneau de la figure 5 ;
- les figures 8 et 9 illustrent deux variantes du panneau de la figure 5 : où les extracteurs sont coniques à section carrée pour la figure 8, où chaque extracteur est commun à une colonne de diodes pour la figure 9 ;
- les figures 10 à 13 illustrent des variantes de la forme des intersections d'un plan de coupe normal avec les parois latérales d'un extracteur pour des diodes selon l'invention : forme « CPC » pour les figures 10 et 11, forme « CPC » tronquée pour la figure 12, forme trapézoïdale inscrite dans une forme « CPC » pour la figure 13 ;
- la figure 14 illustre le tracé d'une parabole de type « CPC » entre une section d'entrée et une section de sortie d'un extracteur selon la variante des figures 10 et 11 ;

Afin de simplifier la description et de faire apparaître les différences et avantages que présente l'invention par rapport à l'état antérieur de la technique, on utilise des références identiques pour les éléments qui assurent les mêmes fonctions.

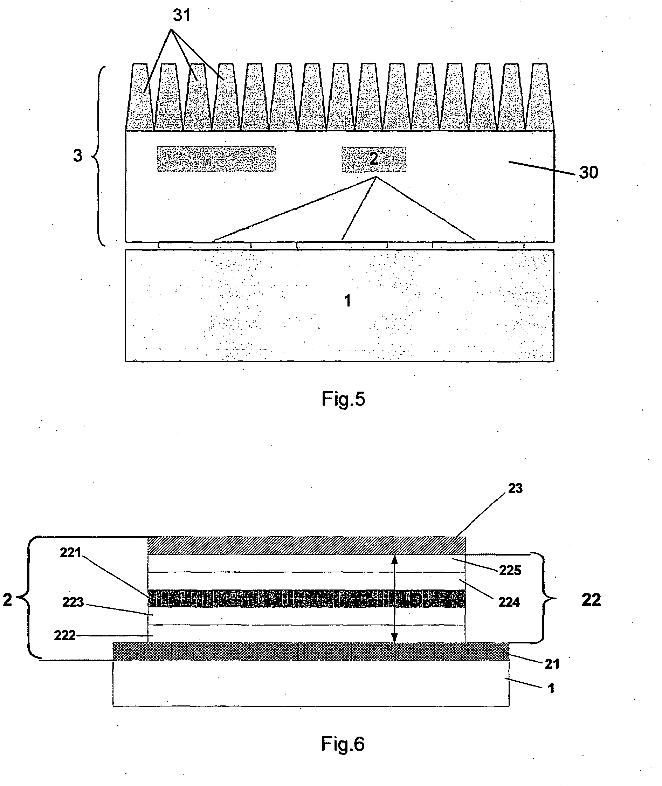

En référence, aux figures 5 à 8, on va maintenant décrire un mode de réalisation de l'invention dans le cas d'un panneau d'affichage d'images comprenant une pluralité de diodes 2 distribuées en lignes et en colonnes et disposées sur un même substrat 1. En référence à la figure 6, chaque diode 2 comprend une électrode inférieure métallique épaisse 21, formant une couche réfléchissante, une couche organique électroluminescente 22, et une électrode supérieure semi-transparente 23, formant également une couche semi-réfléchissante. La couche organique électroluminescente 22 comprend d'une manière classique une sous-couche 222 d'injection et de transport de porteurs d'un premier genre, une sous-couche 223 de blocage des porteurs d'un deuxième genre, une sous-couche électroluminescente à proprement parler 221, une sous-couche 224 de blocage des porteurs du premier genre, et une sous-couche 225 d'injection et de transport de porteurs du deuxième genre. Les genres de porteurs correspondent à des électrons et à des trous. L'électrode supérieure 23 comprend par exemple une sous-couche métallique fine, par exemple en argent, et une sous-couche diélectrique plus épaisse, adaptée pour conférer à l'empilement de ces sous-couches les propriétés optiques requises.

L'espace entre les deux électrodes 21 et 23 forme une cavité optique résonnante ; la distance D_{C} entre ces deux électrodes 21 et 23, qui correspond à la hauteur de cette cavité, est adaptée, comme expliqué précédemment, pour obtenir une résonance des rayons lumineux de longueur d'onde λ_{CN} qui sont émis par la couche 22 dans une direction normale à ces électrodes ; de préférence, on a : 2π . 2 D_{C} / λ_{CN} + Φ = 2 π, où Φ désigne le déphasage global lors de la réflexion d'un rayon de longueur d'onde λ_{CN} sur chacune des électrodes 21, 23.

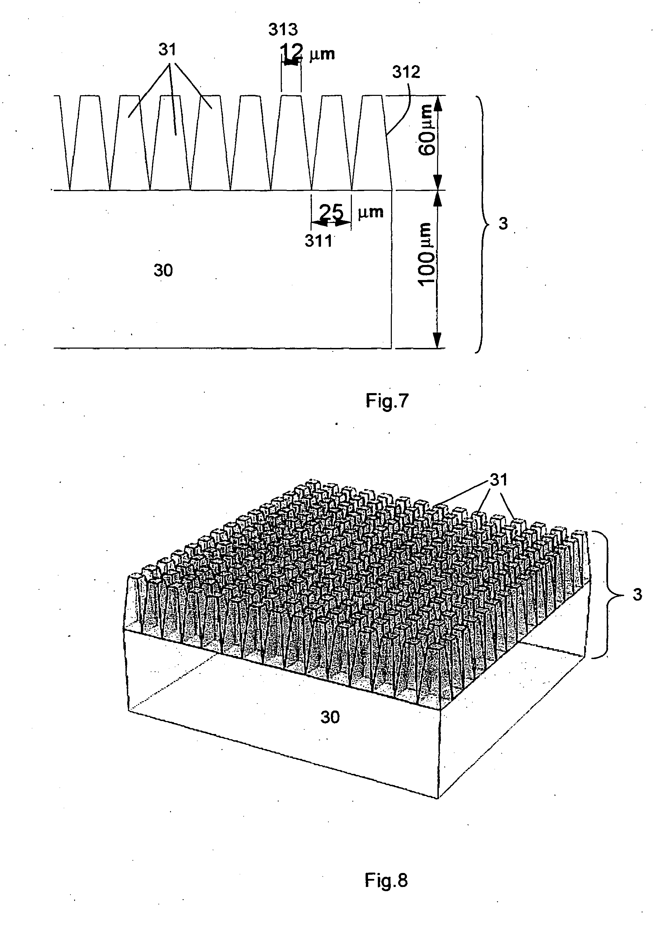

En référencé à la figure 5, la surface émissive des diodes 2, qui émettent au travers de leur électrode supérieure 23, est recouverte d'une couche d'extraction et d'encapsulation 3 ; cette couche 3 comprend une base transparente 30 et un réseau d'extracteurs 31 recouvrant cette base ; en référence à la figure 7, chaque extracteur 31 comprend une section d'entrée carrée 311, une section de sortie également carrée 313, de surface inférieure à celle de la section d'entrée ; chaque extracteur 31 comprend également des parois latérales réfléchissantes 312, qui sont ici planes et dont les contours sont donc trapézoïdaux. En référence à la figure 8, chaque extracteur 31 forme donc un tronc de cône de section carrée, qui comporte donc deux plans de symétrie perpendiculaires, qui sont orientés dans une direction normale. En référence à la figure 5, la surface émissive de chaque diode est optiquement couplée avec la section d'entrée de plusieurs extracteurs 31 via la base transparente 30, la surface de chaque section d'entrée 311 étant largement inférieure, de préférence au moins d'un facteur 10, à la surface émissive de chaque diode. En référence à la figure 7, l'épaisseur de la basé 30 de la couche 3 est par exemple de 100 µm, la hauteur de chaque extracteur par exemple de 60 µm, le côté de sa section d'entrée 311 par exemple de 25 µm, et le côté de sa section de sortie 313 par exemple de 12 µm.

L'ensemble de la couche 3 est par exemple formée par compression dans une feuille de matériau polymère thermoformable transparent, comme du PMMA (polyméthylmétacrylate). Cette couche 3 est assemblée au substrat supportant les diodes, à l'aide d'une colle adaptée pour coupler optiquement les électrodes supérieures 23 des diodes 2 à la base 30 de la couche 3. Comme les sections d'entrée 311 des extracteurs 31 ont une surface largement inférieure à la surface émissive des diodes, l'assemblage est avantageusement réalisé sans contraintes d'alignement.

On obtient un panneau d'affichage dont l'angle d'observation est, grâce à la forme des extracteurs, élargi à la fois dans un plan horizontal et dans un plan vertical.

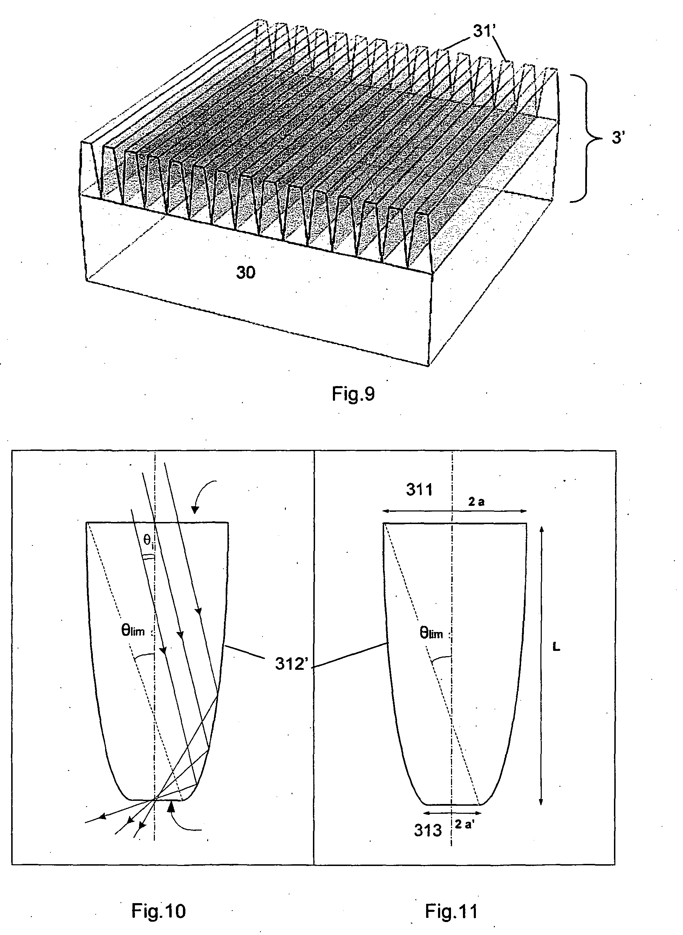

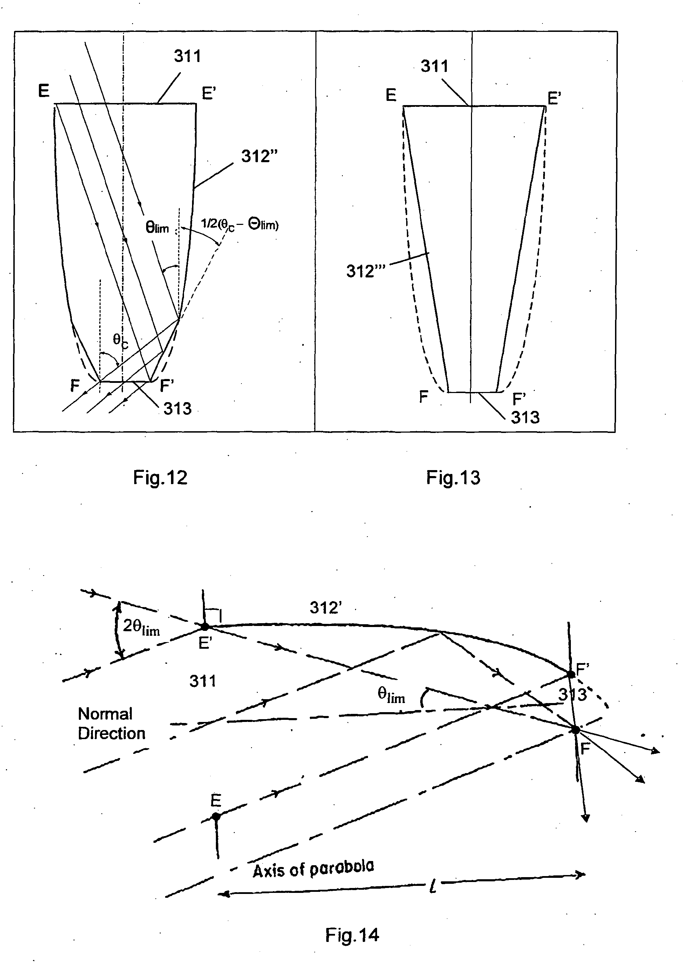

La figure 9 représente une variante de réalisation de ce panneau : chaque extracteur 31' est commun à une pluralité de diodes d'une même colonne et possède un seul plan de symétrie orienté dans une direction normale et parallèle à cette colonne. Dans un plan de coupe quelconque perpendiculaire à ce plan de symétrie et orienté également dans une direction normale, on retrouve les éléments de la figure 7 précédemment décrite. On obtient un panneau d'affichage dont l'angle d'observation est, grâce à la forme des extracteurs, élargi ici uniquement et avantageusement dans un plan horizontal. Selon une variante préférentielle représentée aux figures 10 et 11, les parois latérales réfléchissantes des extracteurs sont de type « CPC ». plus précisément dans ce cas, l'intersection des parois latérales 312' de chaque extracteur 31 avec un plan de coupe perpendiculaire à un plan de symétrie quelconque de l'extracteur forme une parabole de type CPC ; dans le cas d'extracteurs présentant un axe de symétrie, ce plan de coupe passe alors par cet axe ; le détail des caractéristiques du tracé d'une parabole de type CPC est représenté à la figure 14, où les points E et E' représentent les bords de la section d'entrée de l'extracteur, les points F et F' représentent les bords de la section de sortie, où la parabole qui suit le tracé de la ligne F'E' a comme foyer le point F et comme axe une droite parallèle à F'E passant par F, où la parabole qui suit le tracé de la ligne FE a comme foyer le point F' et comme axe une droite parallèle à FE' passant par F'.

Un propriété de telles paraboles « CPC » est que, dans le plan de coupe, la tangente au point de chaque parabole qui est situé à son intersection avec la section d'entrée, ici au point E et E', est parallèle à la direction normale, donc ici perpendiculaire aux plans des sections d'entrée et de sortie.

L'avantage de la forme de parabole « CPC » de cette coupe de l'extracteur est d'apporter une rendement optimal de concentration pour les rayons qui sont émis par la diode avec un angle d'émission inférieur ou égal à l'angle de coupure θₗᵢₘ ; cette angle de coupure correspond alors à l'angle entre ce qu'on appelle les « rayons extrêmes » de cet extracteur, ici FE' et F'E pour respectivement la première et la deuxième parabole « CPC », et la direction normale au plan de la diode. Avantageusement, grâce à cette forme de type « CPC » des extracteurs du panneau selon l'invention, les rayons émis par la diode dans le plan de coupe de l'extracteur avec un angle d'émission inférieur ou égal à cet angle de coupure θₗᵢₘ sont redistribués à la sortie de ces extracteurs dans un angle solide beaucoup plus large comme illustré aux figures 10 et 14 ; l'élargissement de l'angle solide d'émission a évidemment lieu dans le plan de coupe où l'intersection des parois latérales de l'extracteur avec ce plan forme des paraboles de type « CPC »: Ainsi, en utilisant des extracteurs « CPC » ayant plusieurs plans de symétrie, voire un axe de symétrie, donc avec une couche d'extraction analogue à celle de la figure 8, on élargit l'angle solide d'émission des diodes du panneau dans toutes les directions, ainsi qu'évidemment son angle solide d'observation ; à l'inverse, en utilisant des extracteurs « CPC » ayant un seul plan de symétrie, donc avec une couche d'extraction analogue à celle de la figure 9, on élargit l'angle solide d'émission des diodes du panneau principalement dans un plan perpendiculaire à ce plan de symétrie, ainsi qu'évidemment son angle solide d'observation.

Avantageusement, grâce à cette forme de type « CPC » des extracteurs du panneau selon l'invention, les rayons émis par la diode en dehors de l'angle solide limité, dans le plan de coupe de l'extracteur, par l'angle de coupure θₗᵢₘ sont renvoyés par réflexion vers la diode et sont donc exclus de l'angle solide d'émission à la sortie de l'extracteur.

Si λ_{CN} est la longueur d'onde de résonance des rayons lumineux qui sont émis par la couche électroluminescente de la diode dans une direction normale (on a : 2 π. 2 D_{C} / λ_{CN} + Φ = 2 π - cf. supra), la longueur d'onde λ_{C-lim} des rayons lumineux qui présentent un maximum d'émission sous l'angle d'émission θₗᵢₘ égal à l'angle de coupure vaut : λ_{C-lim} = λ_{CN} x cosθₗᵢₘ, du moins si le déphasage global Φ sur chacune des électrodes 21, 23 ne dépend pas sensiblement de la longeur d'onde.

Ainsi, si l'on souhaite exclure une forte proportion des rayons émis par la couche électroluminescente 22 dès lors que ces rayons ont une longueur d'onde exclue d'un intervalle [λ_{CN}, λ_{C-lim}], où λ_{C-lim} est une longueur d'onde de coupure inférieure à λ_{CN}, on détermine la géométrie des extracteurs de manière à ce que l'angle de coupure θₗᵢₘ corresponde à cette longeur d'onde de coupure λ_{C-lim}, plus précisément ici de manière à ce que λ_{C-lim} = λ_{CN} × cosθₗᵢₘ. On voit donc que les extracteurs ont également, en combinaison avec les cavités optiques, une fonction de filtrage spatial des couleurs qui permet d'améliorer ou d'ajuster la pureté de la couleur émise par les diodes.

On voit donc que les extracteurs de forme CPC permettent à la fois d'élargir l'angle d'observation du panneau, ce qui corrige les défauts inhérents aux cavités optiques, et d'améliorer la pureté des couleurs émises.

Selon d'autres variantes telle que celle représentée à la figure 12, les parois latérales réfléchissantes des extracteurs ont une forme intermédiaire entre la forme plane 312'" représentée à la figure 13 et la forme « CPC » précédemment décrite et représentée aux figures 10, 11 et 14 ; plus précisément dans ce cas, l'intersection des parois latérales 312" de chaque extracteur 31 avec un plan de coupe perpendiculaire à un plan de symétrie quelconque de l'extracteur (ou passant par son axe de symétrie) est inscrite dans la surface limitée par la droite EF et la parabole « CPC » passant par les points E et F, et dans la surface limitée par la droite E'F' et la parabole « CPC » passant par les points E' et F'. ; ces limites, droites et paraboles, sont considérées comme inscrites dans ces surfaces. De telles formes dites « intermédiaires » sont avantageusement plus simples à fabriquer que des formes « CPC », tout en apportant des performances tout à fait acceptables sous l'angle de l'élargissement des angles de vues et de la filtration spatiale des couleurs.

La présente invention a été décrite en se référant à un panneau de diodes électroluminescentes organiques pour affichage d'images ; il est évident pour l'homme de l'art qu'elle peut s'appliquer à des panneaux de diodes électroluminescentes inorganiques, à des panneaux de diodes pour éclairage, ou à des diodes isolées, organiques ou inorganiques, sans sortir du cadre des revendications ci-après.

## Revendications

1. Diode (2) comprenant une couche organique électroluminescente (22) intercalée entre une électrode inférieure (21) et une électrode supérieure (23), et entre une couche réfléchissante inférieure et une couche réfléchissante supérieure, formant entre elles une cavité optique résonnante pour un domaine de longueurs d'onde de la lumière apte à être émise par ladite couche électroluminescente (22), l'une (23) au moins des électrodes ainsi que la couche réfléchissante située du même côté que cette électrode par rapport à ladite couche électroluminescente étant transparentes ou semi-transparentes à ladite lumière émise,
**caractérisée en qu'**elle comprend au moins un extracteur de lumière (31) comprenant une section d'entrée de lumière (311) optiquement couplée à la dite couche électroluminescente (22) via ladite électrode (23) et ladite couche réfléchissante qui sont transparentes ou semi-transparentes, une section de sortie de lumière (313) qui est orientée vers l'extérieur de la diode et qui présente une surface inférieure à celle de la section d'entrée, et des parois latérales réfléchissantes (312) qui sont délimitées par ladite section d'entrée (311) et par ladite section de sortie (313).

2. Diode selon la revendication 1 **caractérisée en ce que** les parois latérales réfléchissantes (312) de l'au moins un extracteur (31) ont une forme adaptée pour que tout rayon de lumière émise qui pénètre par sa section d'entrée (311), qui est réfléchi au moins une fois par lesdites parois latérales (312), et qui ressort de l'extracteur par sa section de sortie (313) en ressort sous un angle d'émission supérieur à l'angle d'émission de ce rayon à l'entrée de l'extracteur.

3. Diode selon la revendication 1 ou 2 **caractérisée en ce que** les parois latérales réfléchissantes (312) de l'au moins un extracteur (31) ont une forme adaptée pour qu'il existe un angle dit de coupure θₗᵢₘ tel que :
- les rayons de lumière émise, qui pénètrent par sa section d'entrée (311) sous un angle d'émission inférieur ou égal audit angle de coupure θₗᵢₘ, ressortent de cet extracteur par sa section de sortie (313), ledit angle d'émission étant évalué par rapport à une direction normale à ladite couche réfléchissante inférieure et à ladite couche réfléchissante supérieure ;
- les rayons de lumière émise, qui pénètrent par sa section d'entrée (311) sous un angle d'émission supérieur à cet angle de coupure θₗᵢₘ, ne ressortent pas de l'extracteur par sa section de sortie (313).

4. Diode selon l'une quelconque des revendications 1 à 3 **caractérisée en ce que** lesdites parois latérales réfléchissantes (312) de l'au moins un extracteur (31) sont formées par l'interface entre deux matériaux transparents d'indices optiques différents, et **en ce que** la forme de ces parois et la différence entre ces indices optiques sont adaptées pour que les rayons de lumière émise qui frappent les dites parois en provenance de l'intérieur dudit extracteur (31) et de sa section d'entrée (311) soient réfléchis par réflexion totale interne sur lesdites parois (312).

5. Diode selon l'une quelconque des revendications 1 à 3 **caractérisée en ce que** lesdites parois latérales réfléchissantes sont métallisées.

6. Diode selon l'une quelconque des revendications 1 à 5 **caractérisée en ce que** lesdites parois latérales réfléchissantes de l'extracteur sont deux à deux symétriques par rapport à un plan orienté dans une direction normale à ladite couche réfléchissante inférieure et à ladite couche réfléchissante supérieure.

7. Diode selon l'une quelconque des revendications 1 à 5 **caractérisée en ce que** lesdites parois latérales réfléchissantes présentent un axe de symétrie orienté dans une direction normale à ladite couche réfléchissante inférieure et à ladite couche réfléchissante supérieure.

8. Diode selon la revendication 6 ou 7 **caractérisée en ce que** chacune des deux lignes d'intersection desdites parois latérales (312) avec un plan de coupe quelconque de cette paroi qui est orienté dans une direction qui est normale à ladite couche réfléchissante inférieure et à ladite couche réfléchissante supérieure et qui est perpendiculaire audit plan de symétrie ou avec un plan de coupe quelconque passant par ledit axe de symétrie, forme une droite ou une parabole dont l'axe est dans ladite direction normale.

9. Diode selon la revendication 6 ou 7 **caractérisée en ce que** chacune des deux lignes d'intersection desdites parois latérales (312) avec un plan de coupe quelconque de cette paroi qui est orienté dans une direction qui est normale à ladite couche réfléchissante inférieure et à ladite couche réfléchissante supérieure et qui est perpendiculaire audit plan de symétrie ou avec un plan de coupe quelconque passant par ledit axe de symétrie, est inscrite dans la surface limitée par :
- d'une part, une droite joignant le point (E' ; E) commun à ladite ligne d'intersection et à ladite section d'entrée (311) et le point (F' ; F) commun à ladite ligne d'intersection et à ladite section de sortie (313) ;
- d'autre part, une parabole dont l'axe est approximativement parallèle à la droite joignant ce dernier point commun (F' ; F) et le point (E ; E') commun à l'autre ligne d'intersection, symétrique de la précédente, et à ladite section d'entrée (311), et dont le foyer coïncide approximativement avec le point (F ; F') commun à cette autre ligne d'intersection et au bord de ladite section de sortie (313).

10. Diode selon l'une quelconque des revendications précédentes **caractérisée en ce qu'**elle comprend une pluralité desdits extracteurs (31).

11. Panneau d'affichage d'images comprenant une pluralité de diodes (2) selon l'une quelconque des revendications précédentes, **caractérisée en ce qu'**elles sont réparties sur un même substrat (1).

12. Panneau d'affichage d'images selon la revendication 11 **caractérisé en ce que** les dites diodes (2) sont réparties en lignes et en colonne, et **en ce que** chaque extracteur (31') est commun à plusieurs diodes d'une même colonne.

13. Panneau selon la revendication 12 **caractérisé en ce que**, les dites colonnes étant disposées verticalement pour être adaptées à l'affichage des images, lesdites parois latérales réfléchissantes (312) de chaque extracteur (31') commun à plusieurs diodes d'une même colonne sont deux à deux symétriques par rapport à un plan qui est orienté dans ladite direction normale et qui est parallèle à ladite colonne.

## Claims

1. Diode (2) comprising an organic electroluminescent layer (22) inserted between a lower electrode (21) and an upper electrode (23), and between a lower reflecting layer and an upper reflecting layer, forming between them a resonant optical cavity for a range of wavelengths of light that can be emitted by said electroluminescent layer (22), at least one (23) of the electrodes and the reflecting layer located on the same side as this electrode relative to said electroluminescent layer being transparent or semi-transparent to said emitted light,
**characterized in that** it includes at least one light extractor (31) comprising a light entry section (311), optically coupled to said electroluminescent layer (22) via said electrode (23) and said reflecting layer that are transparent or semi-transparent, a light exit section (313) which is oriented towards the outside of the diode and has a smaller area than that of the entry section, and reflecting side walls (312) which are bounded by said entry section (311) and by said exit section (313).

2. Diode according to Claim 1, **characterized in that** the reflecting side walls (312) of the at least one extractor (31) have a suitable shape so that any emitted light ray that penetrates via its entry section (311), which is reflected at least once by said side walls (312), and which emerges from the extractor via its exit section (313), emerges therefrom at an angle of emission greater than the angle of emission of this ray at the entry of the extractor.

3. Diode according to Claim 1 or 2, **characterized in that** the reflecting side walls (312) of the at least one extractor (31) have a suitable shape so that there is an angle called the cut-off angle θₗᵢₘ such that:
- the emitted light rays, which penetrate via its entry section (311) at an angle of emission not exceeding said cut-off angle θₗᵢₘ, emerge from this extractor via its exit section (313), said angle of emission being measured relative to a direction normal to said lower reflecting layer and to said upper reflecting layer; and
- the emitted light rays, that penetrate via its entry section (311) at an angle of emission greater than this cut-off angle θₗᵢₘ, do not emerge from the extractor via its exit section (313).

4. Diode according to any one of Claims 1 to 3, **characterized in that** said reflecting side walls (312) of the at least one extractor (31) are formed by the interface between two transparent materials having different optical indices and **in that** the shape of these walls and the difference between these optical indices are adapted so that the emitted light rays that strike said walls coming from the inside of said extractor (31) and from its entry section (311) are reflected by total internal reflection off said walls (312).

5. Diode according to any one of Claims 1 to 3, **characterized in that** said reflecting side walls are metallized.

6. Diode according to any one of Claims 1 to 5, **characterized in that** said reflecting side walls of the extractor are pair-wise symmetrical with respect to a plane oriented in a direction normal to said lower reflecting layer and to said upper reflecting layer.

7. Diode according to any one of Claims 1 to 5, **characterized in that** said reflecting side walls have an axis of symmetry oriented in a direction normal to said lower reflecting layer and to said upper reflecting layer.

8. Diode according to Claim 6 or 7, **characterized in that** each of the two lines of intersection of said side walls (312) with any section plane of this wall, which plane is oriented in a direction that is normal to said lower reflecting layer and to said upper reflecting layer and is perpendicular to said plane of symmetry, or with any section plane passing through said axis of symmetry, forms a straight line or a parabola, the axis of which is in said normal direction.

9. Diode according to Claim 6 or 7, **characterized in that** each of the two lines of intersection of said side walls (312) with any section plane of this wall, which plane is oriented in a direction that is normal to said lower reflecting layer and to said upper reflecting layer and is perpendicular to said plane of symmetry, or with any section plane passing through said axis of symmetry, lies within the surface bounded by:
- on the one hand, a straight line joining the point (E' ; E) common to said line of intersection and to said entry section (311) and the point (F' ; F) common to said line of intersection and to said exit section (313); and
- on the other hand, a parabola, the axis of which is approximately parallel to the straight line joining the latter common point (F' ; F) and the point (E ; E') common to the other line of intersection, which is symmetrical with the previous one, and to said entry section (311), and the focus of which coincides approximately with the point (F ; F') common to this other line of intersection and to the edge of said exit section (313).

10. Diode according to any one of the preceding claims, **characterized in that** it includes a plurality of said extractors (31).

11. Image display comprising a plurality of diodes (2) according to any one of the preceding claims, **characterized in that** they are distributed on one and the same substrate (1).

12. Image display according to Claim 11, **characterized in that** said diodes (2) are distributed in rows and columns and **in that** each extractor (31') is common to several diodes of any one column.

13. Display according to Claim 12, **characterized in that**, when said columns are arranged vertically so as to be adapted to the image display, said reflecting side walls (312) of each extractor (31') common to several diodes of any one column are pair-wise symmetrical with respect to a plane that is oriented in said normal direction and is parallel to said column.

## Patentansprüche

1. Diode (2) mit einer elektrolumineszenten organischen Schicht (22), die zwischen einer unteren Elektrode (21) und einer oberen Elektrode (23) und zwischen einer unteren reflektierenden Schicht und einer oberen reflektierenden Schicht angeordnet ist, welche zwischeneinander einen optischen Resonanzhohlraum für einen Wellenlängenbereich des Lichts bilden, das durch die elektrolumineszente Schicht (22) emittiert werden kann, wobei mindestens eine (23) der Elektroden sowie die reflektierende Schicht, die sich in Bezug auf die elektrolumineszente Schicht auf derselben Seite wie diese Elektrode befindet, für das emittierte Licht transparent oder halbtransparent sind, **dadurch gekennzeichnet, dass** sie mindestens einen Lichtextraktor (31), der einen Lichteinfallsquerschnitt (311) aufweist, welcher mit der elektrolumineszenten Schicht (22) über die Elektrode (23) und die reflektierende Schicht, welche transparent oder halbtransparent sind, optisch gekoppelt ist, einen Lichtaustrittsquerschnitt (313) der zum Äußeren der Diode ausgerichtet ist und der eine kleinere Fläche als diejenige des Einfallsquerschnitts aufweist, sowie reflektierende Seitenwände (312) die durch den Einfallsquerschnitt (311) und den Austrittsquerschnitt (313) begrenzt sind, enthält.

2. Diode nach Anspruch 1, **dadurch gekennzeichnet, dass** die reflektierenden Seitenwände (312) des mindestens einen Extraktors (31) eine derart angepasste Form aufweisen, dass jeder Strahl des emittierten Lichts, der über dessen Einfallsquerschnitt (311) eindringt, mindestens einmal an den Seitenwänden (312) reflektiert wird und aus dem Extraktor über dessen Austrittsquerschnitt (313) mit einem Emissionswinkel, der größer ist als der Emissionswinkel dieses Strahls am Extraktoreintritt, wieder austritt.

3. Diode nach Anspruch 1 oder 2, **dadurch gekennzeichnet, dass** die reflektierenden Seitenwände (312) des mindestens einen Extraktors (31) eine derart angepasste Form aufweisen, dass es einen so genannten Schnittwinkel θₗᵢₘ gibt, bei dem
- die Strahlen des emittierten Lichts, die über dessen Einfallsquerschnitt (311) mit einem Emissionswinkel, der kleiner oder gleich dem Schnittwinkel θₗᵢₘ ist, aus diesem Extraktor über dessen Austrittsquerschnitt (313) wieder austreten, wobei der Emissionswinkel in Bezug auf eine Richtung, die normal zu der unteren reflektierenden Schicht und zu der oberen reflektierenden Schicht ist, bestimmt wird,
- die Strahlen des emittierten Lichts, die über dessen Einfallsquerschnitt (311) mit einem Emissionswinkel, der größer als dieser Schnittwinkel θₗᵢₘ ist, nicht aus dem Extraktor über dessen Austrittsquerschnitt (313) wieder austreten.

4. Diode nach einem der Ansprüche 1 bis 3, **dadurch gekennzeichnet, dass** die reflektierenden Seitenwände (312) des mindestens einen Extraktors (31) durch die Schnittstelle zwischen zwei transparenten Materialien mit unterschiedlichen optischen Indizes gebildet sind und dass die Form dieser Wände und der Unterschied zwischen diesen optischen Indizes angepasst sind, damit die Strahlen des emittierten Lichts, die aus dem Inneren des Extraktors (31) und über dessen Einfallsquerschnitt (311) kommend auf die Wände treffen, durch totale interne Reflexion an den Wänden (312) reflektiert werden.

5. Diode nach einem der Ansprüche 1 bis 3, **dadurch gekennzeichnet, dass** die reflektierenden Seitenwände metallisiert sind.

6. Diode nach einem der Ansprüche 1 bis 5, **dadurch gekennzeichnet, dass** die reflektierenden Seitenwände des Extraktors paarweise symmetrisch zu einer Ebene sind, die normal zu der unteren reflektierenden Schicht und zu der oberen reflektierenden Schicht ausgerichtet ist.

7. Diode nach einem der Ansprüche 1 bis 5, **dadurch gekennzeichnet, dass** die reflektierenden Seitenwände eine Symmetrieachse aufweisen, die normal zu der unteren reflektierenden Schicht und zu der oberen reflektierenden Schicht ausgerichtet ist.

8. Diode nach Anspruch 6 oder 7, **dadurch gekennzeichnet, dass** jede der beiden Schnittlinien der Seitenwände (312) mit einer beliebigen Schnittebene dieser Wand, welche Ebene normal zu der unteren reflektierenden Schicht und zu der oberen reflektierenden Schicht und senkrecht zu der Symmetrieebene ausgerichtet ist, oder mit einer beliebigen Schnittebene durch die Symmetrieachse eine Gerade oder eine Parabel bildet, deren Achse in der normalen Richtung liegt.

9. Diode nach Anspruch 6 oder 7, **dadurch gekennzeichnet, dass** jede der beiden Schnittlinien der Seitenwände (312) mit einer beliebigen Schnittebene dieser Wand, welche Ebene normal zu der unteren reflektierenden Schicht und zu der oberen reflektierenden Schicht und senkrecht zu der Symmetrieebene ausgerichtet ist, oder mit einer beliebigen Schnittebene durch die Symmetrieachse in einer Fläche eingeschrieben ist, die begrenzt ist
- zum einen durch eine Gerade, die den der Schnittlinie und dem Einfallsquerschnitt (311) gemeinsamen Punkt (E'; E) mit dem der Schnittlinie und dem Austrittsquerschnitt (313) gemeinsamen Punkt (F'; F) verbindet, und
- zum anderen durch eine Parabel, deren Achse annähernd parallel zu der Geraden verläuft, die diesen letzten gemeinsamen Punkt (F'; F) mit dem Punkt (E; E') verbindet, welcher der anderen Schnittlinie, die zu der vorigen symmetrisch ist, und dem Eintrittsquerschnitt (311) gemeinsam ist, und deren Fokus annähernd mit dem Punkt (F; F') übereinstimmt, der dieser anderen Schnittlinie und dem Rand des Austrittsquerschnitts (313) gemeinsam ist.

10. Diode nach einem der vorhergehenden Ansprüche, **dadurch gekennzeichnet, dass** sie eine Vielzahl der genannten Extraktoren (31) umfasst.

11. Bildschirm mit einer Vielzahl von Dioden (2) nach einem der vorhergehenden Ansprüche, **dadurch gekennzeichnet, dass** sie auf einem selben Substrat (1) verteilt sind.

12. Bildschirm nach Anspruch 11, **dadurch gekennzeichnet, dass** die Dioden (2) zeilen- und spaltenweise verteilt sind und dass jeder Extraktor (31') mehreren Dioden einer selben Spalte gemeinsam ist.

13. Bildschirm nach Anspruch 12, **dadurch gekennzeichnet, dass** bei Spalten, die in Hinblick auf deren Geeignetheit zur Anzeige der Bilder vertikal angeordneten sind, die reflektierenden Seitenwände (312) jedes mehreren Dioden einer selben Spalten gemeinsamen Extraktors (31') paarweise symmetrisch sind zu einer Ebene, die normal ausgerichtet ist und parallel zu der Spalte verläuft.
